Europäisches Patentamt

European Patent Office

Office européen des brevets

(11) Publication number: 0 379 773
A1

# (12) EUROPEAN PATENT APPLICATION

(21) Application number: 89306756.1

(22) Date of filing: 04.07.89

(51) Int. Cl.5: C09J 163/00, C08K 3/04,
H01L 21/58, H01L 23/34

(30) Priority: 27.01.89 US 302414

(43) Date of publication of application:
01.08.90 Bulletin 90/31

(84) Designated Contracting States:
AT BE CH DE ES FR GB GR IT LI LU NL SE

(71) Applicant: DIGITAL EQUIPMENT
CORPORATION
111 Powdermill Road
Maynard Massachusetts 01754-1418(US)

(72) Inventor: Lee, Chune
1836 Cabrillo Street
San Francisco, CA 94121(US)
Inventor: Bradley, Susan Jane
30 Checkerberry Road
E. Hampstead, N.H. 03826(US)
Inventor: Lee, James C.K.
28496 Christopher Lane
Los Altos Hills, CA 94022(US)

(74) Representative: Goodman, Christopher et al
Eric Potter & Clarkson St. Mary's Court St.
Mary's Gate
Nottingham NG1 1LE(GB)

(54) Thermally conductive electrically resistive diamond filled epoxy adhesive.

(57) A diamond particle filled epoxy resin provides an adhesive with high thermal conductivity and electrical resistance. The amount of diamond filler is in the range 75 to 85% by weight. The adhesive can be used to provide an electrically insulating, thermally conductive, bond between two elements, such as an integrated circuit chip and a metal heat sink.

FIG. I

EP 0 379 773 A1

## THERMALLY CONDUCTIVE ELECTRICALLY RESISTIVE DIAMOND FILLED EPOXY ADHESIVE

### BACKGROUND OF THE INVENTION

The present invention relates, in general, to a diamond particle filled epoxy resin that is used as a thermally conductive, electrically resistive, adhesive. Such an adhesive can be used for attaching circuit chips to a cooling structure or system, for example.

High performance digital computers employ electronic circuitry that includes semiconductor circuit chips which are bonded to a plurality of multichip units. To insure reliable operation of the chips, they must be maintained within a predetermined range of operating temperatures. This requires that some form of cooling system or structure be provided for the chips.

One of the biggest problems presented by this requirement, is that of forming a thermally conductive path between the chips and the cooling system or structure. Gases, such as air, can be used but are not nearly as efficient at heat transfer as liquids or solids. Liquids require some form of sealed system that tends to be too complex. Solids thus appear to be the most attractive alternative, however, most of the highly thermally conductive solids are metals that are also electrically conductive. These are undesirable in a circuit chip environment where it is necessary to prevent the formation of damaging electrical shorts, discharges, or the like.

A thermally conductive electrically resistive material that also acts as an adhesive for bonding the chips to the cooling structure or system would be an attractive solution that would work efficiently, and reduce the complexity of the required structures.

Epoxies with different filler materials have been utilized as adhesives for various applications. For example, silver filled epoxies have been utilized in electrically conductive adhesives, while epoxies having small quantities of diamond filler embedded in resins have been utilized as abrasives for grinding wheels, or the like. The present invention seeks to provide a filled epoxy adhesive that will satisfy the requirements of high thermal conductivity, as well as high electrical resistivity.

### SUMMARY OF THE INVENTION

The present invention solves the above problems by providing an epoxy resin adhesive that has been filled with diamond particles or powder to both increase its thermal conductivity and electrical resistivity. It has been discovered that the thermal conductivity and electrical resistivity of an epoxy adhesive can be substantially increased if a large quantity of diamond particle filler is mixed with the adhesive. The quantity of diamond filler needed to realize this result is approximately in the 75 to 85 percent by weight range, which is substantially higher than that of known diamond filled epoxies.

In a number of experiments, it was established that through the addition of the diamond filler, the thermal conductivity of the epoxy can be increased to a level equal to that of a silver filled epoxy, while the electrical resistivity is increased to around $10^{14}$ ohms/cm. The present invention thereby provides an adhesive having a thermal conductivity as high as a typical electrically conductive adhesive, and at the same time, having a high electrical resistance. It is thus very useful in a circuit chip environment, where it is necessary to form thermally conducting, but electrically insulating, paths between the chips and a metal heat sink.

### BRIEF DESCRIPTION OF THE DRAWING

The objects, features, and advantages, of the invention will become apparent from a detailed description of preferred embodiments thereof, taken in conjunction with the accompanying drawing, in which:

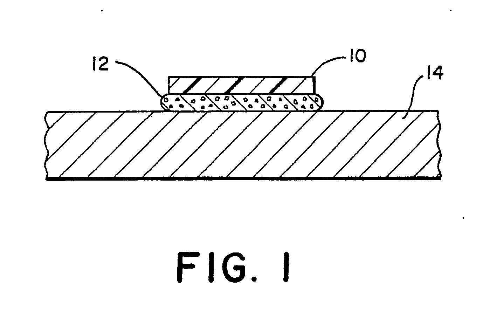

FIG. 1 is a cross sectional side view of an element, such as a circuit chip, bonded to a substrate, such as a heat sink, with the epoxy resin adhesive of the present invention.

### DETAILED DESCRIPTION OF THE PREFERRED EMBODIMENTS

Turning now to a more detailed consideration of the invention, there is illustrated in FIG. 1, a first element 10 which is bonded with an adhesive layer 12 to a second element 14. In the case where first element 10 is a circuit chip, and second element 14 is a metal heat sink, it is desirable that adhesive layer 12 provide a thermally conductive, but electrically insulating, path between the two. As will be discussed below, experimentation has shown that these characteristics will be obtained if adhesive layer 12 is formed from a diamond particle filled epoxy resin.

A number of experiments were conducted using both paste type and film type epoxy resin adhesives. Normally, these adhesives include some form of conventional filler particles, such as boron nitride; silver, alumina; or beryllia. In the experiments, the conventional filler particles were replaced with diamond particles of the same size. The particle mixture of large particles and smaller particles must be optimized so that the small particles can fill in some of the voids between the large particles. In the use of diamond particles, the essentially "cubic" molecular shape lends itself to creating diamond particle blocks which may stack within the epoxy. Since this could provide a greater opportunity for inter-particle spacing, the use of the smaller particles is desirable.

From the experiments, it was determined that the optimum amount of diamond filler epoxy ranges from 75% to 85% of the total weight of the resulting adhesive. That is, if there is to be 100 grams of the final mix, the filler will be 75 to 85 grams. If the amount of diamond filler is below 75%, the thermal conductivity of the adhesive will not be significantly improved. On the other hand, if the amount of filler exceeds 85%, the adhesive becomes difficult to dispense, and does not provide adequate adhering strength.

Typically, the filler particle size should be smaller than the thickness of the adhesive as applied. This application thickness is sometimes know as the "bond line". A bond line can be 0.001" (approximately 25 microns) or less. To insure that there is a good probability that epoxy will surround each of the particles, the particle diameters must be less than the bond line thickness. The general range is from 10 to 15 microns for large particles. Smaller particles about 1/5th the size of the larger particles are added to the mix to fill in any gaps between the larger particles, as discussed previously.

Virtually any type of conventional epoxy resin can be employed as the adhesive. These adhesives can be selected as desired to provide higher or lower operating temperatures. The following is a list of epoxy resins that were employed in the various experiments:

Epichlorohydrin resins of aromatic or aliphatic: poly-hydroxy compounds; poly-hydroxyphenols; poly-methylene phenols; poly-methylene methol phenols; and, similar isomers and homologs. In addition, novolac epoxy resins can be used. Some Chemical Abstract Registry numbers of these epoxies are 28064-14-4; 29640-82-2; 101-90-6; and, 68460-21-9.

The results of the experiments are provided in the table below. In each experiment, a sandwich of silicon, test epoxy, and silicon was employed. A pair of silver conductive epoxies made by Ablestik Company (84-1 LMIT and 84-1 LMI) were utilized as references. Tra Con company provided the epoxy resin paste adhesive (FS 280) with which the diamond was mixed after a hardener was added, while Al Technology provided the epoxy resin film (TK 7759). Each type of sample was tested a number of times, with the average of the results being provided in the table.

| SAMPLE DESCRIPTION | AVERAGE THICKNESS (IN.) | AVERAGE BOND LINE THICKNESS (IN.) | AVERAGE THERMAL CONDUCTIVITY (W/M-C) |
|---|---|---|---|
| GROUP 1 | | | |
| TRA CON FS 280 EPOXY PASTE 81% DIAMOND FILLER | .0511 | .0029 | 2.8 |
| TRA CON FS 280 EPOXY PASTE 78% DIAMOND FILLER | .0153 | .0031 | 2.2 |
| ABLESTIK SILVER FILLED EPOXY 84-1 LMIT | .0507 | .0024 | 2.9 |
| ABLESTIK SILVER FILLED EPOXY 84-1 LMI | .0506 | .0024 | 1.7 |

GROUP 2

| | | | |
|---|---|---|---|
| TRA CON FS 280 EPOXY PASTE 78% DIAMOND FILLER | .0520 | .0032 | 2.3 |
| AI TK 7759 EPOXY FILM WITH 80% DIAMOND, 3 MIL .THICK, 500 g CURE | .0527 | .0038 | 1.2 |
| AI TK 7759 EPOXY FILM WITH 80% DIAMOND, 3 MIL THICK, 200 g CURE | .0531 | .0042 | 1.1 |
| ABLESTIK SILVER FILLED EPOXY 84-1 LMIT | .0501 | .0031 | 1.7 |

In the first group of experiments, epoxy resin paste (Tra Con FS 280) mixed with diamond particles was compared to two different silver filled epoxies. With 81% diamond filler, the epoxy had a thermal conductivity almost equal to that of the highest thermally conductive silver epoxy (Ablestik 84-1 LMIT). With 78% diamond filler, the epoxy's thermal conductivity was considerably lower, although still higher than that of the second silver filled epoxy (Ablestik 84-1 LMI).

Although not specifically recorded for the experiment, the electrical resistivity of the diamond filled epoxies is on the order of $10^{14}$ ohms/cm, as compared to 0.0001 ohms/cm for the typical silver filled conductive epoxy. The first group of experiments thus established that the diamond filled epoxy paste provides excellent thermal conductivity and electrical resistivity characteristics.

In a second group of experiments, epoxy paste with 78% diamond was once again tested, along with a pair of diamond filled epoxy films (Al Technology TK7759). The first silver filled epoxy was also tested again for reference purposes. The results indicate that the thermal conductivity of the films is only about half that of the paste, with the silver filled epoxy falling about halfway between the two. However continued experiments indicate that the films, although providing a lower thermal conductivity than the pastes, nonetheless provide quite acceptable results, and appear to be a better overall material.

Although the invention has been disclosed in terms of preferred embodiments, it will be understood that numerous variations and modifications could be made thereto without departing from the true spirit and scope thereof as set forth in the following claims.

## Claims

1. A highly thermally conductive and electrically resistive adhesive comprising epoxy resin with a diamond particle filler in the range of approximately 75 to 85 percent by weight.

2. The adhesive of claim 1, wherein said diamond particle filler is formed of particles having diameters in the range of approximately 2 to 15 microns.

3. The adhesive of claim 2 wherein said diamond particle filler includes large particles in the range of approximately 10 to 15 microns in diameter, and smaller particles approximately 1/5th the diameter of the large particles.

4. The adhesive of claim 1, wherein the epoxy resin is chosen from the group including epichlorohydrin resins of aromatic or alphatic poly-hydroxy compounds; phenols; poly-methylene phenols; poly-methylene methol phenols; and/or similiar isomers and homologs; or novolac epoxy resins.

5. The adhesive of claim 1, wherein said epoxy resin is in the form of a paste.

6. The adhesive of claim 1, wherein said epoxy resin is in the form of a film

7. A method for adhering a first element to a second element in a thermally conductive and electrically resistive manner, comprising bonding said first and second elements whith a diamond particle filled epoxy resin.

8. The method of claim 7 wherein said bonding step comprises bonding said first and second elements with an epoxy resin having a diamond particle filler in the range of approximately 75 to 85% by weight.

9. The method of claim 8 wherein said bonding step comprises bonding said first and second elements with an epoxy resin having a diamond particle filler in the range of approximately 75 to 85% by weight with the diamond particle diameters being in the range of approximately 2 to 15 microns.

FIG. 1

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | CHEMICAL PATENT INDEX, BASIC ABSTRACTS JOURNAL, week 8633, section A, no. A 0374, accession no. 86-214717/33, Derwent Publications Ltd, London, GB; & JP-A-61 145 266 (SUMITOMO ELEC. IND. K.K.) 02-07-1986<br>----- | 1-9 | C 09 J 163/00<br>C 08 K  3/04<br>H 01 L  21/58<br>H 01 L  23/34 |

TECHNICAL FIELDS
SEARCHED (Int. Cl.5)

C 08 K
C 08 L
C 09 J
H 01 L

The present search report has been drawn up for all claims

| Place of search | Date of completion of the search | Examiner |
|---|---|---|
| THE HAGUE | 02-05-1990 | HOFFMANN K.W. |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons
...................................................................
& : member of the same patent family, corresponding
document

EPO FORM 1503 03.82 (P0401)